# EUROPÄISCHE PATENTSCHRIFT

(11) **EP 2 768 295 B1**
(45) Veröffentlichungstag und Bekanntmachung des Hinweises auf die Patenterteilung: **20.07.2022**
(21) Anmeldenummer: 14000509.1
(22) Anmeldetag: 13.02.2014
(51) Int. Cl.: H05K 5/06, B23K 1/005, B23K 26/20, H05K 7/20

(54) **Verfahren zum Verschließen eines Gehäuses mittels eines optischen Verbindungsverfahrens**
Method for closing a housing by means of an optical connection method
Procédé de fermeture d'un boîtier au moyen d'un procédé de liaison optique

(30) Priorität: 18.02.2013 DE 102013002628
(43) Veröffentlichungstag der Anmeldung: 20.08.2014
(73) Patentinhaber: Tesat-Spacecom GmbH & Co. KG, 71522 Backnang (DE)
(72) Erfinder: Sommerfeldt, Ralph, 71522 Backnang (DE); Möss, Eberhard, D-71540 Murrhardt (DE)
(74) Vertreter: LKGLOBAL Lorenz & Kopf PartG mbB Patentanwälte

(56) Entgegenhaltungen:
- CN-B- 101 150 177
- JP-U- S51 163 868
- US-A- 4 713 520
- US-A- 4 851 627
- US-A- 5 572 065
- US-A1- 2004 108 588
- US-A1- 2007 199 925
- US-A1- 2009 308 168
- US-A1- 2011 185 812
- US-B2- 7 771 551

## Beschreibung

Die vorliegende Erfindung betrifft Gehäusetechnik, nämlich ein Gehäuse sowie ein Verfahren zum Verschließen eines Gehäuses mittels eines optischen Verbindungsverfahrens wie zum Beispiel Laserlöten. Weiter betrifft die Erfindung einen Satelliten aufweisend ein erfindungsgemäßes Gehäuse.

Verschiedene Applikationsszenarien sind bekannt, wie beispielsweise im Rahmen einer Überdruck-, Unterdruck- oder Vakuumapplikation, in denen elektronische Baugruppen in einem hermetisch dichten Gehäuse angeordnet sein sollen. Geeignete elektrische Leitelemente stellen eine elektrische Verbindung von den im Gehäuse angeordneten Bauelementen nach außen bereit. Derartig hermetisch dichte Gehäuse finden beispielsweise in Satellitenapplikationen Verwendung, z.B. bei Hybridschaltungen bzw. Mikrowellenmodulen oder optoelektrischen Hybridmodulen für Satellitenkommunikationsapplikationen.

Ein wichtiger Aspekt ist hierbei das geeignete, hermetische Verschließen eines Gehäuses, nachdem eine Schaltung in dieses eingebracht wurde. Geeignete Verschlussverfahren sind z.B. Laserschweißen, Ofenlöten bzw. Reflow-Löten sowie Widerstandslöten bzw. Widerstandsschweißen.

Beim Laserschweißen wird der Deckel und der Gehäuserand eines Gehäuses durch den Laserstrahl sehr lokal bis zum Schmelzen des Metalls erhitzt. Durch eine vergleichsweise kleine, eingebrachte Energie im Bereich von einigen Joule pro Schweißpunkt erfährt das Bauteil insgesamt nur eine geringe Wärmebelastung.

Beim Ofenlöten wird das Gehäuse samt Deckel auf eine Löttemperatur erhitzt, so dass es zu einer Lötverbindung zwischen zwei Metallflächen kommt. Dabei wird das Bauteil insgesamt thermisch stark belastet.

Beim Widerstandslöten bzw. -schweißen wird Energie in Form eines Stromflusses unter Verwendung von Elektrodenrollen in das Gehäuse bzw. auf Gehäuseelemente eingebracht. Bei dieser Art der Kontaktierung kann ein Übergangswiderstand zwischen Elektrode und einem Gehäuseelement stark variieren, wodurch die Wahrscheinlichkeit für lokale Fehler im Lot ansteigt. Der Energieeintrag auf Gehäuseelemente beim Widerstandslöten bzw. -schweißen liegt zwischen den Energieeinträgen von Laserschweißen und Ofenlöten.

Während beim Laserschweißen ein Metallgehäuse sehr geeignet hermetisch verbunden werden kann, kann im Falle von keramischen Werkstoffen die hohe verwendete Pulsleistung der Laserpulse von einigen kW zu Rissen im Keramikmaterial führen.

US 4 713 520 A beschreibt ein Verfahren und eine Vorrichtung zum Verbinden und hermetisch Versiegeln von Keramikkomponenten. Zwei Keramikkomponenten werden an einer Verbindungsstelle durch Eintrag von Wärme miteinander verbunden.

US 2007/199925 A1 beschreibt ein Verfahren zum Herstellen einer abgedichteten elektronischen Komponente und eine mit diesem Verfahren hergestellte elektronische Komponente. Die elektronische Komponente befindet sich in einem versiegelten Gehäuse.

US 2004/108588 A1 beschreibt den Aufbau eines Gehäuses für elektronische Komponenten in Form von Mikrochips.

US 7 771 551 B2 beschreibt ein Verfahren und eine Vorrichtung zum Anfertigen von Schweißnähten mittels Ultraschallschweißverfahren.

US 2011/185812 A1 beschreibt ein Verfahren zum Verbinden von zwei Gehäuseelementen zu einem Gehäuse. An der Verbindungsstelle zwischen den zwei Gehäuseelementen ist die Materialstärke eines Gehäuseelements reduziert.

US 4 851 627 A beschreibt einen Schalter mit einem Gehäuse, welches mit einem Laser verschweißt wird. An einer Verbindungsstelle ist ein Kanal vorgesehen, welcher das Ausmaß der von der Verbindungsstelle abtransportierten thermischen Energie reduziert.

CN 101 150 177 B beschreibt ein aus mehreren Elementen bestehendes Gehäuse, welche an Verbindungsstellen miteinander verbunden werden. In der Nähe der Verbindungsstellen ist eine Materialeinschnürung angeordnet, um eine thermische Sperre bzw. Barriere zu realisieren.

JP S51 163868 U beschreibt eine elektrische Komponente mit einem Gehäuse. Das Gehäuse besteht aus mehreren Elementen, die mittels thermischer Energie an einer Verbindungsstelle miteinander verbunden werden. In der Nähe der Verbindungsstelle ist eine Materialeinschnürung angeordnet, um eine thermische Sperre bzw. Barriere zu realisieren.

US 2009/308168 A1 beschreibt eine elektronische Komponente in Form eines Sensors mit einem Gehäuse. Das Gehäuse besteht aus mehreren Elementen, an denen eine Isolationsnut zum Reduzieren der Übertragung von thermischer Energie angeordnet ist.

US 5 572 065 A beschreibt den Aufbau eines hermetisch abgedichteten keramischen Gehäuses für elektronische Komponenten.

Erfindungsgemäß wird nun ein Gehäuse sowie ein Verfahren zum Verschließen eines Gehäuses bereitgestellt, wobei die Verbindung unter Verwendung eines optischen Verbindungsverfahrens, wie beispielsweise ein Lötvorgang mit einem Laser, insbesondere Infrarotlaser, erfolgt und wobei eine freie Wärmeausbreitung im Gehäuse durch eine lokale Verminderung der Wärmeleitfähigkeit reduziert wird.

Demgemäß wird ein Gehäuse, ein Verfahren zum Verschließen eines Gehäuses, sowie ein Satellit, aufweisend ein erfindungsgemäßes Gehäuse gemäß den unabhängigen Ansprüchen bereitgestellt. Bevorzugte Ausgestaltungen ergeben sich aus den abhängigen Ansprüchen.

Gemäß der Erfindung wird ein Gehäuse bereitgestellt, aufweisend ein erstes Gehäuseelement, welches ein Deckel ist, und ein zweites Gehäuseelement, welches ein von dem Deckel verschlossenes Innenvolumen aufweist, wobei die Gehäuseelemente wärmeleitfähig ausgebildet sind und wobei die Gehäuseelemente unter Verwendung eines Verbindungsprozesses miteinander verbunden sind, wobei ein Verbindungsmaterial zwischen dem ersten Gehäuseelement und dem zweiten Gehäuseelement zum Verbinden der Gehäuseelemente angeordnet ist und wobei zumindest eines der Gehäuseelemente erhitzbar ist, so dass das Verbindungsmaterial zum Verbinden der Gehäuseelemente aufbereitet wird, wobei zumindest eines der Gehäuseelemente eine Temperatursperre als lokale Verringerung der Wärmeleitfähigkeit aufweist, so dass eine Wärmeausbreitung in dem zumindest einen Gehäuseelement durch die lokale Verringerung der Wärmeleitfähigkeit reduziert ist. Zumindest eines der Gehäuseelemente besteht aus einem Keramikwerkstoff mit Metallüberzug, wobei der Metallüberzug in einem lokalen Bereich einer Verbindungsstelle der Gehäuseelemente abgetragen ist und eine Oberfläche in diesem lokalen Bereich zum Einbringen von optischer Energie eingerichtet ist und einen veränderten Reflexionsgrad aufweist, um eine Absorption der optischen Energie zu erreichen.

Gemäß der Erfindung wird ein Verfahren zum Verschließen eines Gehäuses bereitgestellt, aufweisend Bereitstellen eines ersten Gehäuseelementes, welches ein Deckel ist, und Bereitstellen eines zweiten Gehäuseelementes, welches ein von dem Deckel zu verschließendes Innenvolumen aufweist, wobei die Gehäuseelemente wärmeleitfähig ausgebildet sind und zumindest eines der Gehäuseelemente aus einem Keramikwerkstoff mit Metallüberzug besteht, Vorsehen eines Verbindungsmaterials zwischen dem ersten Gehäuseelement und dem zweiten Gehäuseelement zum Verbinden der Gehäuseelemente und Erhitzen zumindest eines der Gehäuseelemente, so dass das Verbindungsmaterial zum Verbinden der Gehäuseelemente aufbereitet wird, wobei zumindest eines der Gehäuseelemente eine Temperatursperre als lokale Verringerung der Wärmeleitfähigkeit aufweist, so dass eine Wärmeausbreitung in dem zumindest einen Gehäuseelement durch die lokale Verringerung der Wärmeleitfähigkeit reduziert ist; Verbinden der Gehäuseelemente miteinander durch Verwendung optisch eingebrachter Energie, wobei in einem lokalen Bereich einer Verbindungsstelle der Gehäuseelemente der Metallüberzug in dem Bereich, in dem die optische Energie eingebracht wird, abgetragen ist und eine Oberfläche in diesem lokalen Bereich zum Einbringen von optischer Energie eingerichtet ist und einen veränderten Reflexionsgrad aufweist, um eine Absorption der optischen Energie zu erreichen.

Gemäß einer weiteren exemplarischen Ausgestaltung der vorliegenden Erfindung wird ein Satellit mit einem erfindungsgemäßen Gehäuse angegeben.

Beispielsweise kann das erfindungsgemäße Verfahren zur Herstellung eines Gehäuses verwendet werden.

Die fortschreitende Entwicklung bei Hybridbaugruppen führt zu immer kleineren Gehäusen, da u.a. die darin unterzubringenden elektronischen Bauteile eine ständig fortschreitende Miniaturisierung erfahren. Eine nachfolgende Verkleinerung des Gehäuses stellt dabei an ein Verschlussverfahren, mit welchem ein Gehäuse z.B. mit einem Abdeckelement hermetisch verschlossen wird, zunehmend höhere Anforderungen, da bei kleineren Gehäusen während des Verbindungsprozesses durch Aufheizen der Verbindungs- und Fügestellen erhöhte Temperaturen am bzw. im Gehäuse auftreten, welche für die darin untergebrachten elektronischen Komponenten problematisch sein können.

Insbesondere bei Gehäuseelementen aus einem Keramikmaterial, welche ein vergleichsweise großes Wärmeleitvermögen aufweisen, mag eine vergleichsweise große Wärmemenge von einem zum Beispiel mit Laserlicht bestrahlten Deckelelement und einer sich darunter befindlichen Lötstelle in das Keramikgehäuse fließen, wobei diese Wärmeenergie an elektronische Bauteile im Gehäuse weitergeleitet werden kann.

Deshalb mag bei allen Gehäuse-Bauteilen, zum Beispiel Keramikgehäusen, bei denen eine lokale bzw. mittlere thermische Belastung so gering wie möglich gehalten werden soll, ein zu einem Laserschweißprozess alternativer Verbindungsprozess benötigt werden. Weiterhin mag ein Gehäuse benötigt werden, das bei einem Verbindungsprozess die Weitergabe von Wärmeenergie im Gehäuse zumindest reduziert.

Ein solches neuartiges Gehäuse sowie ein solches neuartiges Verbindungsverfahren, beispielsweise ausgebildet als ein Laserlötverfahren, stellt die vorliegende Erfindung bereit.

Beim Laserlöten wird ein Verbindungsmaterial, beispielsweise ein Lotmaterial, zwischen zwei Gehäuseelementen aufgeschmolzen. Dies mag beispielsweise mit einem Laser im Infrarotwellenlängenbereich erfolgen, der sein Licht auf die Oberseite eines Gehäuseelementes aufbringt, typischerweise auf das Deckelelement. Durch ein schnelles Scannen bzw. Abfahren einer gewünschten Kontur oder Verbindungslinie eines Gehäuseelementes oberhalb des Lotes wird dabei ausreichend Energie auf das Gehäuseelement eingebracht, so dass sich im Bereich eines Gehäuseelementes befindliches Lot verflüssigt, somit zum Schmelzen gebracht wird. Das Verbindungsmaterial kann nachfolgend die Gehäuseelemente geeignet verbinden, so dass ein hermetisch dichtes Gehäuse entsteht. Das Gehäuseelement kann dabei aus einem Metall oder Keramikwerkstoff bestehen.

Gemäß der Erfindung ist zumindest eines der Gehäuseelemente ausgebildet aus einem Keramikwerkstoff mit Metallüberzug. Gemäß einer bevorzugten Ausgestaltung der vorliegenden Erfindung mag das Gehäuse nach dem Verbindungsprozess hermetisch dicht ausgebildet sein.

Durch den Übertrag der Wärme durch das Lot auf eine untere Gehäuserandfläche des weiteren Gehäuseelementes wird eine Lotverbindung erzielt, welche nach Abkühlung insbesondere hermetisch dicht ausgebildet ist.

Insbesondere gepulstes Laserlöten stellt eine vergleichsweise sehr geringe thermische Belastung für Gehäuseelemente dar. Dennoch kann diese thermische Belastung für kleine und kleinste Gehäuse thermisch kritisch sein. Aus Sicherheitsgründen mag deshalb der Wärmeeintrag über das Keramikgehäuse auf Komponenten im Innenvolumen vermieden werden. Unter Wärmeeintrag ist hierbei insbesondere die Weiterleitung von Wärmeenergie über die Verbindungs- bzw. Lotstelle hinaus in das Gehäuse und an die dort angeordneten Bauelemente zu verstehen. Durch geeignete konstruktive Maßnahmen mag die Wärmeabfuhr in unerwünschte Bereiche eines Gehäuses jedoch unterbunden bzw. zumindest eingeschränkt werden, so dass ein Gehäuse relativ kühl bleibt. In jedem Fall ist die eigentliche Lötzeit jedoch deutlich kürzer als bei einem Ofenprozess, insbesondere auch, da mit Abschalten des Lasers die Wärmezufuhr im Wesentlichen instantan endet.

Gemäß der Erfindung ist zumindest in einem der beiden Gehäuseelemente, insbesondere zumindest in dem nichterhitzten Gehäuseelement, eine Temperatursperre als lokale Verringerung der Wärmeleitfähigkeit vorgesehen. Gemäß einer bevorzugten Ausgestaltung ist die Temperatursperre als lokale Verringerung der Dicke bzw. als lokale Querschnittsverkleinerung einer Gehäusewandung ausgebildet.

Als geeignete konstruktive Maßnahmen sind dabei Temperatursperren, beispielsweise an Keramikwänden eines Gehäuseelementes, insbesondere desjenigen Gehäuseelementes, das nicht mit dem Laser beaufschlagt wird, vorgesehen. Solche Temperatursperren können als lokale Verringerungen bzw. Einschnürungen der Dicke einer Gehäusewandung ausgebildet sein. Hierdurch wird die Wärmeleitfähigkeit eines Gehäuseelementes, insbesondere lokal, reduziert, so dass sich die Weitergabe von eingebrachter Wärmeenergie über diese Temperatursperre hinaus verzögert, somit nur erschwert erfolgt. Als zusätzlicher Vorteil ergibt sich, dass in dem Bereich eines Gehäuseelementes, das vom Laser aus betrachtet vor der Temperatursperre angeordnet ist, ein Wärmeenergiestau auftritt, wodurch sich der Bereich vor der Temperatursperre bevorzugt durch die eingebrachte Laserenergie erwärmt.

Gemäß einer weiteren bevorzugten Ausgestaltung der vorliegenden Erfindung mag das Verbindungsmaterial ausgebildet sein als ein Mittel aus der Gruppe bestehend aus Lot, Lotpaste, Lotdraht und Lotpreform, insbesondere wobei das Verbindungsmaterial flussmittelfrei ausgebildet sein.

Ist insbesondere bei Raumfahrtapplikationen ein Lötverbindungsprozess thematisiert, so ist hierunter typischerweise flussmittelfreies Löten zu verstehen.

Bei einem flussmittelfreien Lötprozess entstehen im Idealfall keine Schmutzprodukte, welche nach dem Verbindungsprozess noch aufwendig entfernt werden müssen.

Zur Realisierung von flussmittelfreiem Löten mögen die zu verbindenden Oberflächen benetzbar sein, das heißt, es dürfen weder sichtbare Verschmutzungen zu erkennen sein, noch darf die Oberfläche oder die darunter liegende Schicht stark oxidiert bzw. durch Fremdatome verunreinigt sein. Letzteres passiert typischerweise bei unsachgemäßer Lagerung eines Gehäuseelementes beispielsweise an feuchter Raumluft anstatt in einem trockenen Stickstoffschrank.

Die Verunreinigung durch Fremdatome ist dabei nur schwer nachweisbar und wird meist erst bei einem Lötverbindungsprozess selbst erkannt, wenn das Lotmaterial schlecht fließt, weil die Oberfläche schlecht benetzbar ist. Um dem zu begegnen, wird ein Verbindungsprozess typischerweise unter Formiergas, einer Stickstoff-Wasserstoff-Mischung mit 5-10 % Wasserstoff, schlimmstenfalls unter 100 % Wasserstoff durchgeführt. Der Wasserstoff hat dabei reduzierende bzw. sauerstoffbindende Wirkung, die sonst von einem Flussmittel bereitgestellt würde. Ein Einsatz von Formiergas mit geringem Wasserstoffanteil benötigt keine besonderen Sicherheitsvorkehrungen, während bei der Verwendung von reinem Wasserstoff erhebliche Sicherheitsvorkehrungen vorzusehen sind.

Laserlöten ist ein geeignetes Verfahren, um zwei elektrische Kontakte zuverlässig miteinander zu verbinden, ohne benachbarte Bauteile thermisch zu belasten. Das Verbindungsmaterial bzw. Lot mag durch eine automatische Lotdrahtzufuhr, eine geeignet applizierte Lotpaste oder durch ein Lotpreform in die Verbindungsstelle eingebracht sein. Bekannt ist Laserlöten z.B. bei der Bestückung von elektronischen Leiterkarten in SMD-Bauweise bzw. der Bestückung von thermisch empfindlichen elektronischen Baugruppen sowie bei der Erstellung von vollautomatischer Verbindungstechnik bei elektromechanischen Bauteilen wie beispielsweise Schaltern oder Motoren.

Erfindungsgemäß werden zwei Gehäuseelemente mit deren geeigneten Oberflächen mit einem bevorzugt flussmittelfreien Verbindungsmaterial bzw. Lot unter Verwendung eines optischen Verbindungsverfahrens wie beispielsweise Laserlöten verlötet. Ein Laserstrahl wird dazu verwendet, sowohl das Lot bis auf Schmelztemperatur als auch die zu verbindenden Oberflächen, beispielsweise Gehäuserand und Deckel, auf Löttemperatur zu erwärmen. Besonders bevorzugt werden hierbei metallische Oberflächen miteinander verbunden, alternativ durchgeführt werden mag das erfindungsgemäße Verfahren jedoch auch bei Gehäuseelementen aus einem Keramikmaterial.

Gemäß der Erfindung weist das erhitzte Gehäuseelement eine eingerichtete Oberfläche auf zum Einbringen von optischer Energie; wobei die Oberfläche des Gehäuseelementes zumindest lokal im Bereich, in dem die optische Energie eingebracht wird, eine veränderte Oberfläche bzw. einen veränderten Reflexionsgrad der Oberfläche aufweist.

Insbesondere metallische Oberflächen weisen meist einen hohen Reflexionsgrad auf, wodurch eingestrahltes Laserlicht zu einem signifikanten Anteil reflektiert wird. Ein Aspekt der vorliegenden Erfindung sieht dabei die Veränderung eines Reflexionsgrades einer Gehäuseelementoberfläche vor. Die Oberfläche im Bereich der Lötung wird gezielt derart verändert, dass eine akzeptable Absorption des Laserlichtes erzielbar ist. Eine Veränderung dabei ist, dass ein Oberflächenplating, somit eine Beschichtung der Gehäuseoberfläche, oft als Gold auf Nickel ausgeführt, abgetragen wird. Eine weitere Verwendung kann sein, dass die Oberfläche aufgeraut wird. Auch hierfür mag ein geeigneter Laser verwendet werden, welcher eine Ablation der Oberfläche durchführen mag. Besonders bevorzugt mag hierbei das gleiche Laserelement wie für den Verbindungsprozess verwendet werden, möglicherweise mit veränderten Parametern angesteuert.

Eine Veränderung der Oberfläche ist dabei nicht über die gesamte Gehäuseelementoberfläche notwendig, der lokale Bereich der Lötstelle ist ausreichend.

Gemäß einer weiteren bevorzugten Ausgestaltung der vorliegenden Erfindung mag das zumindest eine Gehäuseelement bei Einbringen der optischen Energie in einer vorgegebenen Bahn abgefahren werden. Gemäß einer weiteren bevorzugten Ausgestaltung der vorliegenden Erfindung mag ein Laserelement vorgesehen sein sowohl zum Einrichten der Oberfläche zum Einbringen der Verbindungsenergie, als auch zum Einbringen der Verbindungsenergie selbst.

Zur Erzielung einer gleichmäßigen Erwärmung der zu verlötenden Flächen mag die Wärmeenergie mittels eines Laserscanners, somit eines steuerbaren Laserstrahls, berührungslos in Form der Gehäuse-Deckel-Kontur auf ein Gehäuseelement aufgebracht werden. Eine solche Gehäuse-Deckel-Kontur entspricht dabei im Wesentlichen der Kontur der gewünschten Verbindung zwischen den Gehäuseelementen und wird dabei meist rechteckig ausgeführt, wobei auch andere Formen denkbar sind, welche jedoch einem konkreten Gehäuseaufbau geschuldet sind. Das Laserlicht wird über eine Oberfläche eines Gehäuseelementes absorbiert, welche die Leitung der Wärmeenergie durch das Gehäuseelement zum Verbindungsmaterial bzw. Lot bereitstellt. Eine weitere Leitung der Wärmeenergie durch das Lot auf das zweite zu verlötende Gehäuseelement erlaubt nach einer gewissen Aufwärmzeit das Schmelzen des Lots und somit das Herstellen einer mechanisch festen und hermetisch dichten Verbindung zwischen den beiden Gehäuseelementen mittels des geschmolzenen Lotmaterials.

Besonders bevorzugt finden flussmittelfreie Lote Verwendung, so dass eine Reinigung der Gehäuseelemente nach dem Verbindungsvorgang nicht notwendig ist. Um flussmittelfreie Lote sicher verwenden zu können, wird meist eine Aktivierung der zu verlötenden Oberfläche benötigt. Eine Aktivierung kann hierbei beim Ausheizen der Gehäuseelemente, typischerweise ein Gehäuse und Deckel, in einem Vakuumofen, beispielsweise zur Entfernung von Feuchtigkeit, durch Spülen mit Formiergas bei erhöhter Temperatur erfolgen, gegebenenfalls in Kombination mit zwischenliegenden Vakuumzyklen. Alternativ kann der Verbindungsprozess unter Verwendung flussmittelfreier Lote selbst unter Formiergas bzw. einem Stickstoff/Wasserstoff-Gemisch durchgeführt werden.

Gemäß einer weiteren bevorzugten Ausgestaltung der vorliegenden Erfindung mag weiterhin eine Verarbeitungstemperatur beim Verbinden der beiden Gehäuseelemente überwacht werden, insbesondere durch eine IR-Kamera und/oder einen Temperatursensor.

Zur Erhöhung einer Prozesssicherheit kann während des Verbindungsprozesses eine sogenannte In-Prozess-Kontrolle beim Lötprozess erfolgen. Dies mag beispielsweise durch eine Infrarotkamera, einen Infrarottemperaturfühler oder eine andere geeignete Temperaturmessung erfolgen, welche im Wesentlichen überprüfen mag, ob der Bereich, in dem der Verbindungsprozess die beiden Gehäuseelemente verbinden soll, eine geeignete Prozesstemperatur aufweist, die zum gewünschten Ergebnis führt.

Gemäß einer weiteren bevorzugten Ausgestaltung der vorliegenden Erfindung mögen beim Verbinden die beiden Gehäuseelemente in ihrer relativen Position zueinander fixierbar sein durch eine Fixierungsvorrichtung, insbesondere durch eine mechanische Andruckvorrichtung, ein Gewicht oder ein Magnetsystem, weiter insbesondere durch ein selbstzentrierendes Magnetsystem.

Weiterhin mag bei einem Gehäuseelement eine geeignete mechanische Befestigung vorgesehen sein, damit z.B. ein oberer Lotpartner, typischerweise ein Deckel mit Lotpreform bei einem Lötprozess auf dem geschmolzenen und damit flüssigen Verbindungsmaterial nicht aufschwimmt und sich örtlich versetzt. So mag an diesem Gehäuseelement ein Gewichtselement, ein Magnetelement, insbesondere ein selbstzentrierendes Magnetelement bzw. ein Gehäuseelement relativ zum weiteren Gehäuseelement selbst zentrierendes Magnetelement vorgesehen sein. Auch eine mechanische Andruckvorrichtung, insbesondere außerhalb des Laserfokus, durch den ein Laserstrahl geführt werden muss, mag ein Gehäuseelement mit konstanter Kraft gegen das weitere Gehäuseelement pressen bzw. dieses niederhalten.

Gemäß der Erfindung erfolgt der Verbindungsprozess unter Verwendung optisch eingebrachter Energie. In einer Ausführungsform ist das optische Verbindungsverfahren als ein optisches Lötverfahren, insbesondere als ein Laserlötverfahren ausgebildet.

Der erfindungsgemäße Verbindungsprozess bzw. Laserlötprozess hat dabei eine gute Reproduzierbarkeit mit hoher Ausbeute und zeigt insbesondere geringen thermo-mechanischen Stress an metallisierten Keramikgehäusen. Beim Laserlöten wird Wärmeenergie mittels Licht, somit optisch, sehr lokal begrenzt zugeführt.

Das Vorsehen einer geeigneten Ablenkvorrichtung für den Laserstrahl, beispielsweise schnell verstellbare Galvanospiegel im kH-Bereich, ermöglicht eine nahezu beliebige Abfahrkontur für den Laserstrahl auf einem Gehäuseelement, so dass im Idealfall ausschließlich der Bereich des Verbindungsmaterials bzw. Lotes vollständig als Ganzes erwärmt wird und sich nahezu zeitgleich verflüssigt.

Nachfolgend wird anhand der beigefügten Zeichnungen näher auf Ausführungsbeispiele der vorliegenden Erfindung eingegangen. Es zeigen:
- **Fig. 1a, b**: eine Ausgestaltung eines Gehäuses;
- **Fig. 2a, b**: eine weitere Ausgestaltung eines Gehäuses mit Temperatursperren; und
- **Fig. 3**: eine weitere Ausgestaltung eines Gehäuses;
- **Fig. 4**: eine Ausgestaltung eines Lotpreforms; und
- **Fig. 5**: eine exemplarische Ausgestaltung eines Verfahrens zum Verschließen eines Gehäuses mittels eines optischen Verbindungsverfahrens.

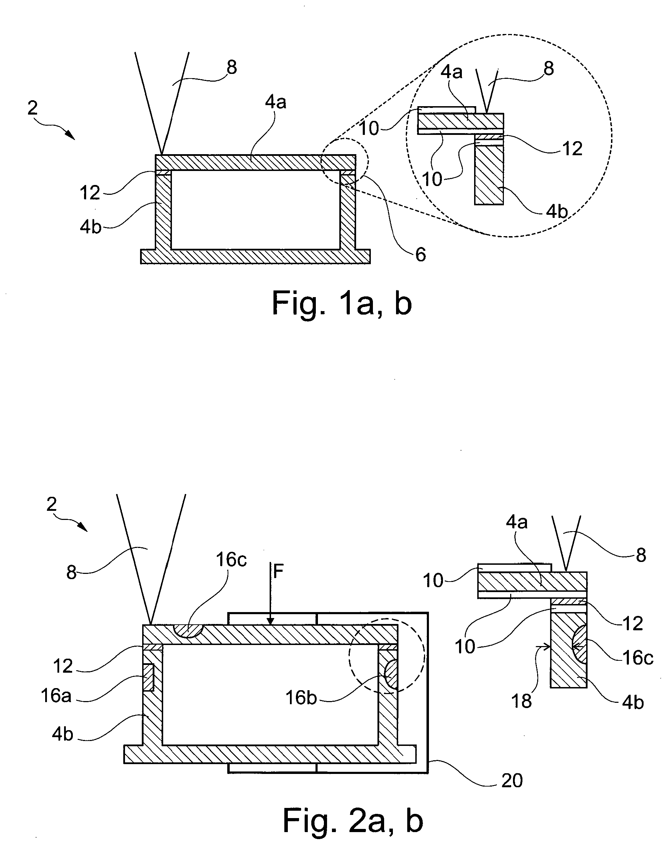

Weiter Bezug nehmend auf Figuren 1a, b wird eine Ausgestaltung eines Gehäuses dargestellt.

Figur 1a zeigt einen schematischen Querschnitt durch ein Gehäuse 2, bestehend aus einem ersten Gehäuseelement 4a, einem Abdeckelement oder Deckel, sowie einem zweiten Gehäuseelement 4b bzw. der Gehäusebasis. Figur 1b zeigt eine Detailvergrößerung eines Kontaktbereichs 6 zwischen erstem Gehäuseelement und zweitem Gehäuseelement 4a, b.

Das Gehäuse 2 weist ein Innenvolumen auf, in welchem in geeigneter Weise elektronische Bauelemente angeordnet sein können. Nach der Verbindung des ersten Gehäuseelementes 4a mit dem zweiten Gehäuseelement 4b kann das Gehäuse 2 insbesondere hermetisch dicht sein.

Das erste Gehäuseelement 4a ist in Figuren 1a, b exemplarisch als rechteckiges, plattenförmiges Element dargestellt, während das zweite Gehäuseelement 4b im Wesentlichen U-förmig im Querschnitt bzw. topfförmig ausgebildet ist. Zwischen dem ersten Gehäuseelement 4a und dem zweiten Gehäuseelement 4b ist ein Verbindungsmaterial 12, zum Beispiel ein Lotpreform, angeordnet. Ein Laserstrahl 8 beaufschlagt das erste Gehäuseelement 4a mit einer optischen Energiezufuhr durch Laserlicht. Durch den Laserstrahl 8 wird somit zunächst das erste Gehäuseelement 4a erwärmt, insbesondere ausschließlich im lokalen Bereich 6 bzw. an der Verbindungsstelle bzw. Kontaktstelle zwischen erstem und zweitem Gehäuseelement 4a, b. Durch die lokale Erwärmung wird Wärmeenergie auch an das Verbindungsmaterial 12 weitergegeben, welches dadurch aufbereitet wird, beispielsweise verflüssigt wird, und gleichzeitig Energie an das zweite Gehäuseelement 4b weitergibt. Durch die eingebrachte Energie mittels des Laserstrahls 8 im lokalen Verbindungsbereich 6 der Gehäuseelemente 4a, b wird somit das Verbindungsmaterial 12 verflüssigt und verbindet, insbesondere nach Abkühlung, das erste und zweite Gehäuseelement 4a, b, insbesondere hermetisch.

Eine detailliertere Ausgestaltung des lokalen Verbindungsbereichs 6 ist in Figur 1b dargestellt.

In Figur 1b zu erkennen ist, dass das erste Gehäuseelement 4a beidseitig eine Beschichtung bzw. ein Plating 10 aus einem geeigneten Material, beispielsweise aus Gold, aufweist. In dem Bereich, in dem der Laserstrahl 8 auf das erste Gehäuseelement 4a einwirkt, ist jedoch, zumindest auf der Einwirkungsseite des Laserstrahls 8, kein solches Plating 10 vorgesehen. Dieses mag bei der Herstellung des ersten Gehäuseelementes 4a ausgespart oder aber vor dem Verbindungsprozess abgetragen worden sein.

Insbesondere ein geeignet eingestellter Laserstrahl 8, möglicherweise generiert durch dasselbe Laserelement, das zur Verbindung der Gehäusehälften eingesetzt wird, findet für die Abtragung bzw. Ablation des Platings 10 im Verbindungsbereich 6 Verwendung. Auch kann die Oberfläche des ersten Gehäuseelementes 4a im Bereich des fehlenden Platings 10 weiterhin aufgeraut sein, um somit nochmals verbessert die optische Energie des Laserstrahls 8 aufnehmen zu können. Das zweite Gehäuseelement 4b weist ebenfalls ein Plating 10 auf, insbesondere in dem Bereich, in dem auch das Verbindungsmaterial 12 angeordnet ist.

Das erste, zweite Gehäuseelement 4a, b mag exemplarisch als ein Keramikmaterial ausgeführt sein, während das Plating 10 aus einem Metall, insbesondere Gold ausgebildet ist. Das Verbindungsmaterial 12 kann somit mit dem metallischen Plating 10 bevorzugt durch den erfindungsgemäßen Verbindungsprozess verbunden werden.

Weiter Bezug nehmend auf Figuren 2a, b wird eine weitere Ausgestaltung eines Gehäuses mit Temperatursperren dargestellt.

Die Figuren 2a, b entsprechen dabei der Darstellung der Figuren 1a, b, wobei jedoch das erste bzw. zweite Gehäuseelement 4a, b Temperatursperren 16a, b, c aufweisen, welche als Querschnittsverkleinerung 18 in der Wandungsdicke der Gehäuseelemente 4a, b ausgebildet sind.

Die Temperatursperre 16a weist dabei einen im Wesentlichen rechteckigen Querschnitt auf, während die Temperatursperre 16b einen bogenförmigen Querschnitt bzw. eine kreisförmige Einkerbung in das Material des zweiten Gehäuseelementes 4b darstellt. Eine solche Temperatursperre 16a, b, c erschwert bzw. reduziert die Wärmedissipation von einer Seite der Temperatursperre 16 auf die jeweils andere Seite, beispielsweise von einer laserzugewandten auf eine laserabgewandte Seite. Aufgrund einer derartigen Temperatursperre verbleibt auf der dem Laser zugewandten Seite eine erhöhte Energiemenge im Material, wodurch sich dort gegebenenfalls eine höhere lokale Temperatur als ohne die Temperatursperre ergibt. Dies mag auch die Verwendung von verringerter Laserenergie bei gleichbleibendem Verbindungsergebnis ermöglichen.

Das erste Gehäuseelement 4a weist ebenfalls eine Temperatursperre 16c, ausgebildet mit einer Kreisform, auf. Die Ausgestaltung der Form einer Temperatursperre 16a, b, c ist dabei dem jeweiligen Herstellungsverfahren der Vertiefung und insbesondere den dabei verwendeten Werkzeugen geschuldet.

Bevorzugt umläuft die Temperatursperre 16 den vollständigen Umfang eines Gehäuseelementes und grenzt so den Verbindungsbereich 6 gegenüber dem restlichen Gehäuseelement ab. Dadurch konzentriert sich die zugeführte Energie im laserzugewandten Bereich eines Gehäuseelementes. Die Querschnittsverkleinerung 18 der Gehäusewandung des zweiten Gehäuseelementes 4b ist exemplarisch in Figur 2b dargestellt.

Im Weiteren schematisch dargestellt ist eine Fixierungsvorrichtung 20, die das erste Gehäuseelement 4a und das zweite Gehäuseelement 4b geeignet relativ zueinander fixiert und somit während des Verbindungsprozesses festlegt.

Insbesondere bei einem Verflüssigen des Verbindungsmaterials 12 verhindert die Fixierungsvorrichtung 20 ein Verrutschen der Gehäuseelemente 4a, b zueinander. Alternativ mag zumindest ein Gehäuseelement, in Figur 2a das erste Gehäuseelement 4a, mit einer Gewichtskraft F durch ein Gewicht beaufschlagt sein, welche gleichfalls ein Verrutschen bzw. eine relative Positionsänderung der Gehäuseelemente 4a, b zueinander verhindert.

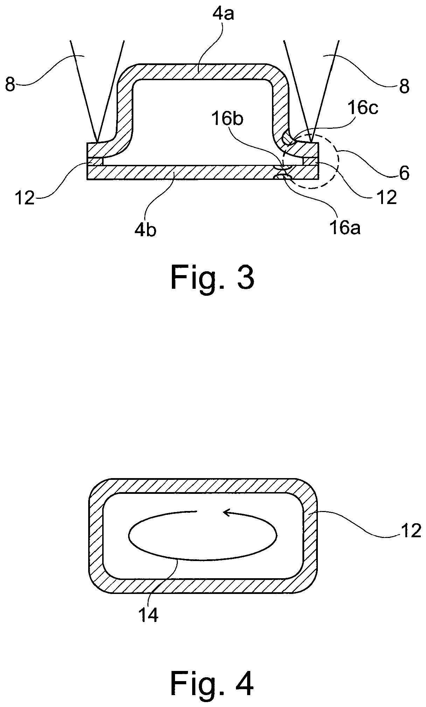

Weiter Bezug nehmend auf Figur 3 wird eine weitere Ausgestaltung eines Gehäuses dargestellt.

Figur 3 zeigt einen etwas anders ausgestalteten Gehäusequerschnitt mit einem im Wesentlichen rechteckigen bzw. plattenförmigen zweiten Gehäuseelement 4b sowie einem glockenförmigen Gehäuseelement 4a. Im lokalen Verbindungsbereich 6 zwischen erstem und zweitem Gehäuseelement 4a, b mögen die Gehäuseelemente der Figur 3 verbleichbar den Gehäuseelementen der Figuren 1b bzw. 2b ausgestaltet sein, was jedoch in Figur 3 nicht näher dargestellt ist. So weisen die Gehäuseelemente ein Plating auf, das in dem Bereich, in dem der Laserstrahl 8 auf das erste Gehäuseelement 4a auftrifft, geeignet abgetragen ist.

Ein Laser 8 erwärmt in Figur 3 das erste Gehäuseelement 4a im Verbindungsbereich 6, wodurch die beiden Gehäuseelemente 4a, b wiederum mit dem Laserlötverfahren hermetisch verbindbar sind.

Weiterhin sind wiederum Temperatursperren 16a, b, c in Figur 3 dargestellt, wobei das zweite Gehäuseelement 4b eine beidseitige Einschnürung als Temperatursperren 16a, b aufweist, das erste Gehäuseelement 4a wiederum eine einseitige Einschnürung 16c.

Temperatursperren16a, b, c können bei Verwendung eines geeigneten Lasers 8 auch unmittelbar vor dem eigentlichen Verbindungsprozess in das Material der Gehäuseelemente 4a, b eingebracht werden, bevorzugt durch dasselbe Laserelement 8, welches für den Verbindungsprozess und/oder die Ablation des Platings 10 verwendet wird.

Weiter Bezug nehmend auf Figur 4 wird eine Ausgestaltung eines Lotpreforms dargestellt.

Figur 4 zeigt eine Aufsicht auf ein Verbindungsmaterial 12, ausgebildet als ein Lotpreform. Das Lotpreform kann hierbei ein gestanztes Element sein, das vollständig aus Verbindungsmaterial 12 besteht. Aufgrund der Einstückigkeit des Verbindungsmaterials 12 kann dieses gut gehandhabt und insbesondere auf einfache Weise zwischen einem ersten und einem zweiten Gehäuseelement 4a, b angeordnet werden. Die im Inneren des Lotpreforms 12 angedeutete Kreisbahn 14 stellt einen möglichen Umlauf eines Laserstrahls um den Verbindungsbereich 6 zwischen erstem und zweitem Gehäuseelement 4a, b, somit den Laserweg 14, dar. So ermöglicht eine im Wesentlichen kontinuierliche kreisförmige bzw. rechteckförmige Bahn-Bewegung des Laserstrahls 8 auf dem ersten Gehäuseelement 4a im Verbindungsbereich 6 eine gleichmäßige Erwärmung des ersten Gehäuseelementes 4a, des Lotpreforms 12 sowie des zweiten Gehäuseelementes 4b, so dass der Verbindungsprozess, in Form eines Laserlötprozesses, an allen Punkten des Verbindungsbereichs 6 im Wesentlichen gleichzeitig erfolgt.

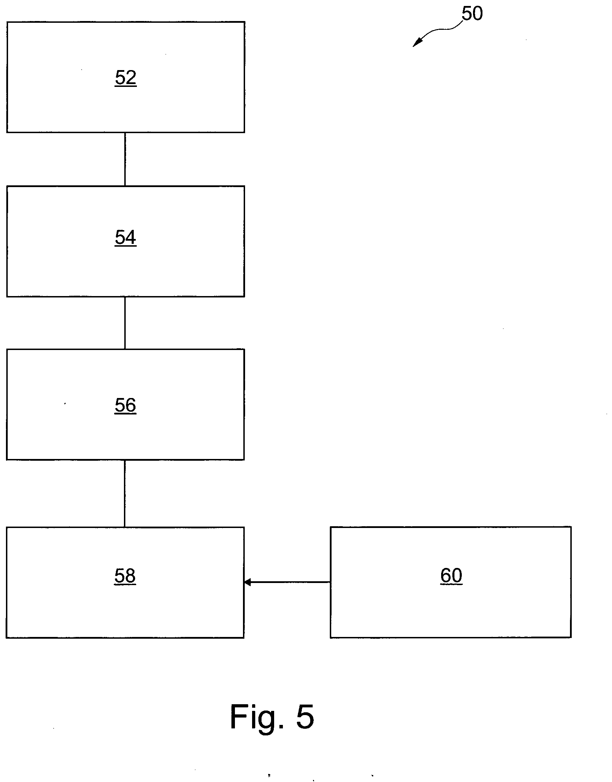

Weiter Bezug nehmend auf Figur 5 wird eine Ausgestaltung eines Verfahrens zum Verschließen eines Gehäuses mittels eines optischen Verbindungsverfahrens dargestellt.

Figur 5 zeigt dabei ein Verfahren 50 zum Verschließen eines Gehäuses 2, aufweisend Bereitstellen 52 eines ersten Gehäuseelementes 4a, welches ein Deckel ist, und Bereitstellen 54 eines zweiten Gehäuseelementes 4b, welches ein von dem Deckel zu verschließendes Innenvolumen aufweist, wobei die Gehäuseelemente 4a, b wärmeleitfähig ausgebildet sind und zumindest eines der Gehäuseelemente aus einem Keramikwerkstoff mit Metallüberzug besteht und wobei die Gehäuseelemente 4a, b unter Verwendung eines optischen Verbindungsprozesses verbindbar sind, Vorsehen 56 eines Verbindungsmaterials 12 zwischen dem ersten Gehäuseelement 4a und dem zweiten Gehäuseelement 4b zum Verbinden der Gehäuseelemente 4a, b und Erhitzen 58 zumindest eines der Gehäuseelemente 4a, b, so dass das Verbindungsmaterial 12 zum Verbinden der Gehäuseelemente 4a, b aufbereitet wird, wobei zumindest eines der Gehäuseelemente 4a, b eine Temperatursperre als lokale Verringerung der Wärmeleitfähigkeit aufweist, so dass eine Wärmeausbreitung in dem zumindest einen Gehäuseelement 4a, b durch die lokale Verringerung der Wärmeleitfähigkeit reduziert ist, und Verbinden der Gehäuseelemente miteinander durch Verwendung optisch eingebrachter Energie, wobei in einem lokalen Bereich einer Verbindungsstelle der Gehäuseelemente der Metallüberzug in dem Bereich, in dem die optische Energie eingebracht wird, abgetragen ist und eine Oberfläche in diesem lokalen Bereich zum Einbringen von optischer Energie eingerichtet ist und einen veränderten Reflexionsgrad aufweist, um eine Absorption der optischen Energie zu erreichen.

### Bezugszeichenliste

- 2: Gehäuse
- 4a, b: erstes, zweites Gehäuseelement
- 6: Verbindungsbereich, lokaler
- 8: Laserelement/Laserstrahl
- 10: Beschichtung/Plating
- 12: Verbindungsmaterial/Lotpreform
- 14: Laserweg
- 16a, b, c: Temperatursperre
- 18: Querschnittsverkleinerung
- 20: Fixierungsvorrichtung/Andruckvorrichtung
- 50: Verfahren zum Verschließen eines Gehäuses
- 52: Bereitstellen eines ersten Gehäuseelementes
- 54: Bereitstellen eines zweiten Gehäuseelementes
- 56: Vorsehen eines Verbindungsmaterials
- 58: Erhitzen eines Gehäuseelementes
- 60: Überwachen der Verarbeitungstemperatur

## Patentansprüche

1. Gehäuse (2), aufweisend
ein erstes Gehäuseelement (4a), welches ein Deckel ist; und
ein zweites Gehäuseelement (4b), welches ein von dem Deckel verschlossenes Innenvolumen aufweist;
wobei die Gehäuseelemente (4a, b) wärmeleitfähig ausgebildet sind; und
wobei die Gehäuseelemente (4a, b) unter Verwendung eines Verbindungsprozesses miteinander verbunden sind;
wobei ein Verbindungsmaterial (12) zwischen dem ersten Gehäuseelement (4a) und dem zweiten Gehäuseelement (4b) zum Verbinden der Gehäuseelemente (4a, b) angeordnet ist; und
wobei zumindest eines der Gehäuseelemente (4a, b) erhitzbar ist, so dass das Verbindungsmaterial (12) zum Verbinden der Gehäuseelemente (4a, b) aufbereitet wird;
wobei zumindest eines der Gehäuseelemente (4a, b) eine Temperatursperre (16a, b, c) als lokale Verringerung der Wärmeleitfähigkeit aufweist, so dass eine Wärmeausbreitung in dem zumindest einen Gehäuseelement (4a, b) durch die lokale Verringerung der Wärmeleitfähigkeit reduziert ist;
**dadurch gekennzeichnet, dass**
zumindest eines der Gehäuseelemente (4a, b) aus einem Keramikwerkstoff mit Metallüberzug besteht;
in einem lokalen Bereich einer Verbindungsstelle der Gehäuseelemente (4a, b) der Metallüberzug abgetragen ist und eine Oberfläche in diesem lokalen Bereich zum Einbringen von optischer Energie eingerichtet ist und einen veränderten Reflexionsgrad aufweist, um eine Absorption der optischen Energie zu erreichen.

2. Gehäuse nach Anspruch 1, wobei die Temperatursperre (16a, b, c) als lokale Verringerung der Dicke bzw. als lokale Querschnittsverkleinerung (18) einer Gehäusewandung ausgebildet ist.

3. Gehäuse gemäß einem der vorhergehenden Ansprüche, wobei das Verbindungsmaterial (12) ausgebildet ist als ein Mittel aus der Gruppe bestehend aus Lot, Lotpaste, Lotdraht und Lotpreform.

4. Gehäuse gemäß einem der vorhergehenden Ansprüche, wobei das Gehäuse (2) hermetisch dicht ausgebildet ist.

5. Verfahren (50) zum Verschließen eines Gehäuses (2), aufweisend
Bereitstellen (52) eines ersten Gehäuseelementes (4a), welches ein Deckel ist; und
Bereitstellen (54) eines zweiten Gehäuseelementes (4b), welches ein von dem Deckel zu verschließendes Innenvolumen aufweist;
wobei die Gehäuseelemente (4a, b) wärmeleitfähig ausgebildet sind und zumindest eines der Gehäuseelemente (4a, b) aus einem Keramikwerkstoff mit Metallüberzug besteht; und
Vorsehen (56) eines Verbindungsmaterials (12) zwischen dem ersten Gehäuseelement (4a) und dem zweiten Gehäuseelement (4b) zum Verbinden der Gehäuseelemente (4a, b); und
Erhitzen (58) zumindest eines der Gehäuseelemente (4a, b), so dass das Verbindungsmaterial (12) zum Verbinden der Gehäuseelemente (4a, b) aufbereitet wird;
wobei zumindest eines der Gehäuseelemente (4a, b) eine Temperatursperre (16a, b, c) als lokale Verringerung der Wärmeleitfähigkeit aufweist, so dass eine Wärmeausbreitung in dem zumindest einen Gehäuseelement (4a, b) durch die lokale Verringerung der Wärmeleitfähigkeit reduziert ist;
Verbinden der Gehäuseelemente miteinander durch Verwendung optisch eingebrachter Energie;
wobei in einem lokalen Bereich einer Verbindungsstelle der Gehäuseelemente (4a, b) der Metallüberzug in dem Bereich, in dem die optische Energie eingebracht wird, abgetragen ist und eine Oberfläche in diesem lokalen Bereich zum Einbringen von optischer Energie eingerichtet ist und einen veränderten Reflexionsgrad aufweist, um eine Absorption der optischen Energie zu erreichen.

6. Verfahren gemäß Anspruch 5, wobei der Verbindungsprozess unter Verwendung optisch eingebrachter Energie als ein optisches Lötverfahren ausgebildet ist.

7. Verfahren gemäß Anspruch 6, wobei ein Laserelement (8) vorgesehen ist sowohl zum Einrichten der Oberfläche zum Einbringen der optischen Energie als auch zum Einbringen der Verbindungsenergie.

8. Verfahren gemäß einem der Ansprüche 5 bis 7, wobei das zumindest eine Gehäuseelement (4a, b) bei Einbringen der optischen Energie in einer vorgegebenen Bahn (14) abgefahren wird.

9. Verfahren gemäß einem der Ansprüche 5 bis 8, weiterhin aufweisend Überwachen (60) der Verarbeitungstemperatur beim Verbinden der beiden Gehäuseelemente (4a, b).

10. Verfahren gemäß einem der Ansprüche 6 bis 9, wobei beim Verbinden die beiden Gehäuseelemente (4a, b) in ihrer relativen Position zueinander durch eine Fixierungsvorrichtung (20) fixiert werden durch eine mechanische Andruckvorrichtung (20), ein Gewicht (F), ein Magnetsystem, oder ein selbstzentrierendes Magnetsystem.

11. Satellit, aufweisend ein Gehäuse (2) gemäß einem der Ansprüche 1 bis 4.

## Claims

1. Housing (2), comprising
a first housing element (4a), which is a cover; and
a second housing element (4b), which is an internal volume closed by the cover;
wherein the housing elements (4a, b) are of thermally conductive design; and
wherein the housing elements (4a, b) are connected to one another using a connecting process;
wherein a connecting material (12) is arranged between the first housing element (4a) and the second housing element (4b) for connection of the housing elements (4a, b);
wherein at least one of the housing elements (4a, b) can be heated, such that the connecting material (12) is prepared for connecting the housing elements (4a, b);
wherein at least one of the housing elements (4a, b) comprises a temperature barrier (16a, b, c) in the form of a local reduction of the thermal conductivity, such that a propagation of heat in the at least one housing element (4a, b) is reduced by the local reduction of the thermal conductivity;
**characterized in that**
at least one of the housing elements (4a, b) is composed of a ceramic material with a metal coat;
the metal coat is deposited in a local region of a connecting point of the housing elements (4a, b), and a surface in this local region is configured for the introduction of optical energy and has an altered reflectance in order to absorb the optical energy.

2. Housing according to Claim 1, wherein the temperature barrier (16a, b, c) is in the form of a local reduction of the thickness or in the form of a local cross-sectional reduction (18) of a housing wall.

3. Housing according to either of the preceding claims, wherein the connecting material (12) is in the form of a means from the group consisting of solder, solder paste, solder wire and solder preform.

4. Housing according to one of the preceding claims, wherein the housing (2) is of hermetically sealed design.

5. Method (50) for closing a housing (2), comprising
providing (52) a first housing element (4a), which is a cover; and
providing (54) a second housing element (4b), which comprises an internal volume to be closed by the cover;
wherein the housing elements (4a, b) are of thermally conductive design, and at least one of the housing elements (4a, b) is composed of a ceramic material with a metal coat; and
providing (56) a connecting material (12) between the first housing element (4a) and the second housing element (4b) for connection of the housing elements (4a, b); and
heating (58) at least one of the housing elements (4a, b), such that the connecting material (12) is prepared for connecting the housing elements (4a, b);
wherein at least one of the housing elements (4a, b) comprises a temperature barrier (16a, b, c) in the form of a local reduction of the thermal conductivity, such that a propagation of heat in the at least one housing element (4a, b) is reduced by the local reduction of the thermal conductivity;
connecting the housing elements to one another by using optically introduced energy;
wherein, in a local region of a connecting point of the housing elements (4a, b), the metal coat is deposited in the region in which the optical energy is introduced, and a surface in this local region is configured for the introduction of optical energy and has an altered reflectance in order to absorb the optical energy.

6. Method according to Claim 5, wherein the connecting process using optically introduced energy is in the form of a soldering method.

7. Method according to Claim 6, wherein a laser element (8) is provided both for configuring the surface for the introduction of the optical energy and for introducing the connecting energy.

8. Method according to one of Claims 5 to 7, wherein the at least one housing element (4a, b) is travelled along in a predefined path (14) when the optical energy is being introduced.

9. Method according to one of Claims 5 to 8, furthermore comprising monitoring (60) the processing temperature when the two housing elements (4a, b) are being connected.

10. Method according to one of Claims 6 to 9, wherein, during the connecting operation, the position of the two housing elements (4a, b) relative to one another is fixed by a fixing device (20) by a mechanical pressure-exerting device (20), a weight (F), a magnet system, or a self-centring magnet system.

11. Satellite, comprising a housing (2) according to one of Claims 1 to 4.

## Revendications

1. Boîtier (2), comprenant
un premier élément de boîtier (4a), qui est un couvercle ; et
un deuxième élément de boîtier (4b), qui comprend un volume intérieur fermé par le couvercle ;
les éléments de boîtier (4a, b) étant configurés sous forme thermoconductrice ; et
les éléments de boîtier (4a, b) étant reliés entre eux en utilisant un processus de liaison ;
un matériau de liaison (12) étant agencé entre le premier élément de boîtier (4a) et le deuxième élément de boîtier (4b) pour relier les éléments de boîtier (4a, b) ; et
au moins l'un des éléments de boîtier (4a, b) pouvant être chauffé de telle sorte que le matériau de liaison (12) est préparé pour relier les éléments de boîtier (4a, b) ;
au moins l'un des éléments de boîtier (4a, b) comprenant une barrière thermique (16a, b, c) en tant que réduction locale de la conductivité thermique, de telle sorte qu'une propagation de la chaleur dans l'au moins un élément de boîtier (4a, b) est réduite par la réduction locale de la conductivité thermique ;
**caractérisé en ce que**
au moins l'un des éléments de boîtier (4a, b) est constitué d'un matériau céramique avec revêtement métallique ;
dans une zone locale d'un emplacement de liaison des éléments de boîtier (4a, b), le revêtement métallique est enlevé et une surface dans cette zone locale est adaptée pour introduire de l'énergie optique et présente un degré de réflexion modifié afin d'obtenir une absorption de l'énergie optique.

2. Boîtier selon la revendication 1, la barrière thermique (16a, b, c) étant configurée sous forme de réduction locale de l'épaisseur ou sous forme de diminution de section transversale locale (18) d'une paroi de boîtier.

3. Boîtier selon l'une quelconque des revendications précédentes, le matériau de liaison (12) étant configuré sous la forme d'un agent du groupe constitué par un métal d'apport de brasage, une pâte de brasage, un fil de brasage et une préforme de brasage.

4. Boîtier (3) selon l'une quelconque des revendications précédentes, le boîtier (2) étant configuré sous forme hermétiquement étanche.

5. Procédé (50) pour fermer un boîtier (2), comprenant
la fourniture (52) d'un premier élément de boîtier (4a), qui est un couvercle ; et
la fourniture (54) d'un deuxième élément de boîtier (4b), qui comprend un volume intérieur à fermer par le couvercle ;
les éléments de boîtier (4a, b) étant configurés sous forme thermoconductrice et au moins l'un des éléments de boîtier (4a, b) étant constitué d'un matériau céramique avec revêtement métallique ; et
la prévision (56) d'un matériau de liaison (12) entre le premier élément de boîtier (4a) et le deuxième élément de boîtier (4b) pour relier les éléments de boîtier (4a, b) ; et
le chauffage (58) d'au moins l'un des éléments de boîtier (4a, b) de telle sorte que le matériau de liaison (12) est préparé pour relier les éléments de boîtier (4a, b) ;
au moins l'un des éléments de boîtier (4a, b) comprenant une barrière thermique (16a, b, c) en tant que réduction locale de la conductivité thermique, de telle sorte qu'une propagation de la chaleur dans l'au moins un élément de boîtier (4a, b) est réduite par la réduction locale de la conductivité thermique ;
la liaison des éléments de boîtier entre eux en utilisant de l'énergie introduite optiquement ;
dans une zone locale d'un emplacement de liaison des éléments de boîtier (4a, b), le revêtement métallique étant enlevé dans la zone où l'énergie optique est introduite, et une surface dans cette zone locale étant adaptée pour introduire de l'énergie optique et présentant un degré de réflexion modifié afin d'obtenir une absorption de l'énergie optique.

6. Procédé selon la revendication 5, le processus de liaison étant configuré sous la forme d'un procédé de brasage optique utilisant de l'énergie introduite optiquement.

7. Procédé selon la revendication 6, un élément laser (8) étant prévu à la fois pour adapter la surface pour introduire l'énergie optique et pour introduire l'énergie de liaison.

8. Procédé selon l'une quelconque des revendications 5 à 7, l'au moins un élément de boîtier (4a, b) étant déplacé selon une trajectoire prédéterminée (14) lors de l'introduction de l'énergie optique.

9. Procédé selon l'une quelconque des revendications 5 à 8, comprenant en outre le contrôle (60) de la température d'usinage lors de la liaison des deux éléments de boîtier (4a, b).

10. Procédé selon l'une quelconque des revendications 6 à 9, lors de la liaison, les deux éléments de boîtier (4a, b) étant fixés dans leur position relative l'un par rapport à l'autre par un dispositif de fixation (20) par un dispositif de pression mécanique (20), un poids (F), un système magnétique, ou un système magnétique à centrage automatique.

11. Satellite, comprenant un boîtier (2) selon l'une quelconque des revendications 1 à 4.
